# EUROPEAN PATENT APPLICATION

(11) **EP 4 421 460 A1**
(43) Date of publication of application: **28.08.2024**
(21) Application number: 24156830.2
(22) Date of filing: 09.02.2024
(51) Int. Cl.: G01J 1/02, G01J 1/04, G01J 1/42, G01S 3/783, G01S 3/784

(54) **ELECTRONIC DEVICES WITH AMBIENT LIGHT ANGULAR DETECTION**

(30) Priority: 21.02.2023 US 202363486209 P; 29.11.2023 US 202318523573
(71) Applicant: Apple Inc., Cupertino, CA 95014 (US)
(72) Inventor: DODSON, Christopher M., Denver (US); SHAO, Guocheng, Palo Alto (US)
(74) Representative: COPA Copenhagen Patents

(57) **Abstract**

An electronic device may have an optical sensor such as an ambient light sensor for detecting ambient light. The ambient light sensor may include one or more photodetectors and light control layers disposed over the photodetectors. The light control layers may include light control structures forming concentric strips of opaque or light absorbing material. The light control layers may include one layer of light control structures, two layers of light control structures, or three or more layers of light control structures separated by one or more intervening transparent substrates. The electronic device may include associated control circuitry configured to compute angular information on the ambient light based on readings output from the one or more photodetectors.

## Description

This application claims priority to U.S. patent application No. 18/523,573, filed November 29, 2023, and U.S. provisional patent application No. 63/486,209, filed February 21, 2023, which are hereby incorporated by reference herein in their entireties.

### Field

This relates generally to electronic devices, and, more particularly, to electronic devices with light sensors.

### Background

Electronic devices such as laptop computers, cellular telephones, and other equipment are sometimes provided with light sensors. For example, ambient light sensors may be incorporated into an electronic device to provide the electronic device with information on current lighting conditions. It can be challenging to design ambient light sensors with angular detection capabilities.

### Summary

An electronic device may have an optical sensor such as an ambient light sensor for gathering ambient light measurements. The electronic device may also include a display formed from an array of pixels. The ambient light sensor may be located under the array of pixels, or in a border region adjacent to the display.

An aspect of the disclosure provides an electronic device having an optical sensor and control circuitry. The optical sensor can include one or more photodetectors and light control layers disposed over the one or more photodetectors and including light control structures forming concentric strips of opaque material. The control circuitry can be configured to compute angular information associated with the received ambient light based on readings generated from the one or more photodiodes. The concentric strips can include circular concentric strips of opaque material or partially opaque material. The opaque material can be black ink, colored ink, or metallic material. The light control layers can be formed on one or more transparent substrates. The one or more photodiodes can be part of a single annular photodetector or a plurality of ring segment shaped photodetectors. The light control layers can include a diffuser surrounded by the concentric strips of opaque material. The optical sensor can include a color sensor disposed below the diffuser and surrounded by the photodetectors.

An aspect of the disclosure provides a method of operating an optical sensor. The method can include using a group of photodetectors in the optical sensor to output count values, computing a lux reading by combining the count values output from the group of photodetectors; and estimating an angle reading based a difference of the count values. The optical sensor can include a Moiré film covering the group of photodetectors. The method can further include computing a corrected lux reading based on the estimated angle reading and updating the angle reading based on the corrected lux reading. The method can include identifying a maximum count value from among the count values and/or computing ratios of respective pairs of the count values.

An aspect of the disclosure provides an optical sensor that includes one or more photodetectors and light control layers disposed over the one or more photodetectors. The light control layers can include a transparent substrate, a first layer of light control structures forming concentric strips on a first surface of the transparent substrate, and a second layer of light control structures forming concentric strips on a second surface of the transparent substrate. The first and second layers of light control structures can form concentric strips of opaque material or partially opaque material. The light control layers can further include a third layer of light control structures forming concentric strips and an additional transparent substrate interposed between the second layer of light control structures and the third layer of light control structures. The concentric strips in the first layer of light control structures can be formed from a first type of material; the concentric strips in the second layer of light control structures can be formed from a second type of material different than the first type of material; and the concentric strips in the third layer of light control structures can be formed from a third type of material different than the first and second types of material. The first type of material can be pigmented ink configured to absorb red light; the second type of material can be pigmented ink configured to absorb green light; and the third type of material can be pigmented ink configured to absorb blue light.

### Brief Description of the Drawings

FIG. 1 is a schematic diagram of an illustrative electronic device having display and sensor components in accordance with some embodiments.
FIG. 2 is a top view of an illustrative head-mounted device in accordance with some embodiments.
FIG. 3 is side view of an illustrative ambient light sensor having one or more light control layer(s) in accordance with some embodiments.
FIG. 4 is top (plan) view of illustrative circular light control structures disposed over multiple photodetectors in accordance with some embodiments.
FIG. 5 is a top (plan) view of an illustrative annular photodetector in accordance with some embodiments.
FIG. 6 is a cross-sectional side view of illustrative light control layers having light control structures disposed on one side of a substrate in accordance with some embodiments.
FIG. 7 is a cross-sectional side view of illustrative light control layers having light control structures disposed on two sides of a substrate in accordance with some embodiments.
FIG. 8 is a cross-sectional side view of illustrative light control layers having three different types of light control structures in accordance with some embodiments.
FIG. 9 is top (plan) view of illustrative circular light control structures disposed over multiple photodetectors and surrounding a diffuser structure in accordance with some embodiments.
FIG. 10 is side view of the circular light control structures and the diffuser structure of FIG. 9 disposed over angle sensing photodetectors and a color sensor in accordance with some embodiments.
FIG. 11 is a top (plan) view of illustrative square-shaped light control structures disposed over four separate photodetectors in accordance with some embodiments.
FIG. 12 is a top (plan) view of illustrative pentagonal light control structures disposed over five separate photodetectors in accordance with some embodiments.
FIG. 13 is a top (plan) view of illustrative hexagonal light control structures disposed over six separate photodetectors in accordance with some embodiments.
FIG. 14 is a top (plan) view of illustrative octagonal light control structures disposed over eight separate photodetectors in accordance with some embodiments.
FIG. 15 is a plot showing an angular response of an ambient light sensor with only a single photodetector in accordance with some embodiments.
FIG. 16 is a plot showing an angular response of an ambient light sensor with multiple photodetectors in accordance with some embodiments.
FIG. 17 is a flow chart of illustrative steps for operating an ambient light sensor with angular detection capabilities in accordance with some embodiments.

### Detailed Description

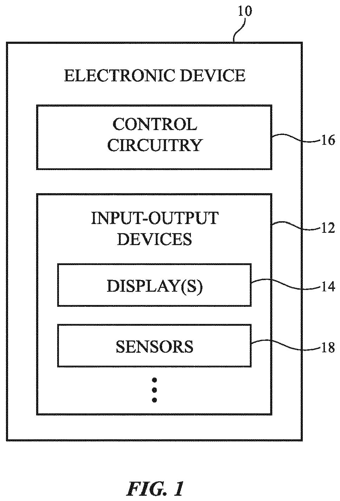

An illustrative electronic device of the type that may be provided with one or more light sensors is shown in FIG. 1. Electronic device 10 may be a computing device such as a laptop computer, a computer monitor containing an embedded computer, a tablet computer, a cellular telephone, a media player, or other handheld or portable electronic device, a smaller device such as a wristwatch or other device worn on a user's wrist, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, equipment that implements the functionality of two or more of these devices, or other electronic equipment.

As shown in FIG. 1, electronic device 10 may have control circuitry 16. Control circuitry 16 may include storage and processing circuitry for supporting the operation of device 10. The storage and processing circuitry may include storage such as hard disk drive storage, nonvolatile memory (e.g., flash memory or other electrically-programmable-read-only memory configured to form a solid state drive), volatile memory (e.g., static or dynamic random-access-memory), etc. Processing circuitry in control circuitry 16 may be used to control the operation of device 10. The processing circuitry may be based on one or more microprocessors, microcontrollers, digital signal processors, baseband processors, power management units, audio chips, application specific integrated circuits, etc. Control circuitry 16 may include communications circuitry for supporting wired and/or wireless communications between device 10 and external equipment. For example, control circuitry 16 may include wireless communications circuitry such as cellular telephone communications circuitry and wireless local area network communications circuitry.

Input-output circuitry in device 10 such as input-output devices 12 may be used to allow data to be supplied to device 10 and to allow data to be provided from device 10 to external devices. Input-output devices 12 may include buttons, joysticks, scrolling wheels, touch pads, key pads, keyboards, microphones, speakers, tone generators, vibrators, cameras, light-emitting diodes and other status indicators, data ports, etc. A user can control the operation of device 10 by supplying commands through input-output devices 12 and may receive status information and other output from device 10 using the output resources of input-output devices 12.

Input-output devices 12 may include one or more displays such as display 14. Display 14 may be a touch screen display that includes a touch sensor for gathering touch input from a user or display 14 may be insensitive to touch. A touch sensor for display 14 may be based on an array of capacitive touch sensor electrodes, acoustic touch sensor structures, resistive touch components, force-based touch sensor structures, a light-based touch sensor, or other suitable touch sensor arrangements. Display 14 may be include any desired display technology, and may be an organic light-emitting diode (OLED) display, a liquid crystal display (LCD), a microLED display, or any other desired type of display.

Input-output devices 12 may also include sensors 18. Sensors 18 may include a capacitive sensor, a light-based proximity sensor, a magnetic sensor, an accelerometer, a force sensor, a touch sensor, a temperature sensor, a pressure sensor, a compass, a microphone, a radio-frequency sensor, a three-dimensional image sensor, a camera, a light-based position sensor (e.g., a lidar sensor), and other sensors. Sensors 18 may also include one or more light detectors that are configured to detect ambient light. Sensors 18 may, for example, include one or more monochrome ambient light sensors and one or more color ambient light sensors that are configured to measure ambient light from the environment in which device 10 is operated. A monochrome ambient light sensor may be used to measure ambient light intensity. A color ambient light sensor may be used to measure the color (e.g., color spectrum, color temperature, color coordinates, etc.) of ambient light and may be used to measure ambient light intensity.

Electronic device 10 may include one or more ambient light sensors. In some configurations, the ambient light sensor may be located in a portion of device 10 where there is a potential for light interference from light-emitting components in device 10 that emit stray light. For example, the ambient light sensor may be overlapped by a pixel array in display 14 (e.g., an active area of the display that is configured to display images) that has a potential to generate stray light. The display pixel array may have transparent portions (e.g., transparent gaps between metal traces and other opaque structures) or may have a window opening so that ambient light may pass through the pixel array to the overlapped ambient light sensor. By locating the ambient light sensor behind the active area of the display, the appearance of device 10 may be enhanced and/or more area can be freed up for other components and functions. Configurations in which the ambient light sensor is located under an inactive display area (e.g., a notch or pixel array window opening that is free of pixels) or is located elsewhere within device 10 may also be used. In some embodiments, display 14 and the ambient light sensor may be disposed on different or opposing sides of device 10.

During operation, control circuitry 16 may gather measurements with the ambient light sensor while controlling display 14 or other light source that generates stray light. Control circuitry 16 may then process the data gathered from the ambient light sensor to produce accurate ambient light measurements even in scenarios in which sensor data has been gathered in the presence of electromagnetic interference. For example, device 10 may include communications circuitry, including wireless transceiver circuitry, which may emit radio-frequency signals. Additionally or alternatively, device 10 may operate in environments in which there are ambient radio-frequency signals (e.g., radio-frequency signals that are emitted by other devices). These radio-frequency signals may cause electromagnetic interference with ambient light sensors in device 10.

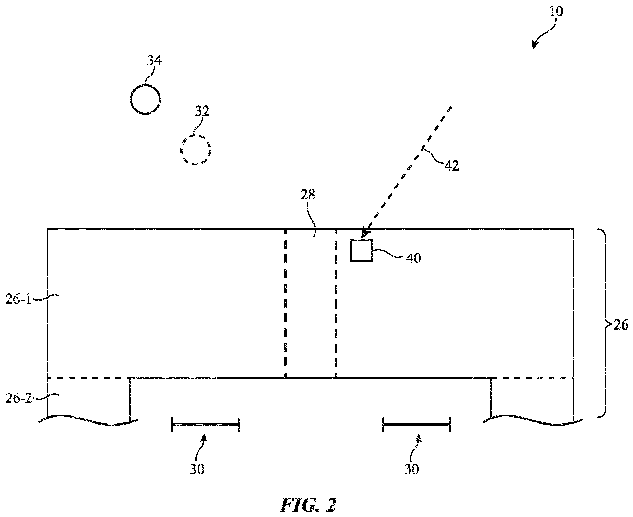

FIG. 2 is a top view of electronic device 10 in an illustrative configuration in which electronic device 10 is a head-mounted device such as a pair of mixed-reality glasses. As shown in FIG. 2, electronic device 10 may include head-mounted support structure 26 to house the components of device 10 and to support device 10 on a user's head. Support structure 26 may include, for example, an eyeglass frame having structures that form housing walls and other structures at the front of device 10 (e.g., support structures 26-1, which may form frame structures at the front of device 10 such as nose bridge 28, a frame structure with rims and/or other structures forming lens openings, end pieces, and/or other housing structures) and additional structures such as straps, temples (sometimes referred to as arms), or other supplemental support structures (e.g., support structures 26-2) that help to hold the front of the frame and the components supported by the front frame portion on a user's face so that the user's eyes are located within eye boxes 30.

During operation of device 10, images are presented to a user's eyes in eye boxes 30. Eye boxes 30 include a left eye box that receives a left image and a right eye box that receives a right image. Device 10 may include a left display system with a left display (projector) that presents the left image to the left eye box and a right display system with a right display (projector) that presents the right image to the right eye box. In an illustrative configuration, each display system may have an optical combiner system (sometimes referred to as an optical combiner assembly, eyeglass lens, head-mounted display lens, etc.) that helps combine display images (e.g., computer-generated image 32 of FIG. 2, sometimes referred to as a virtual image) with real-world images (e.g., light from real-world objects such as object 34 of FIG. 2). Optical combiner systems may, for example, be formed from eyeglass lenses that include waveguides with output couplers formed from holograms. The waveguides may be formed from polymer layers and/or glass layers that transport images internally (e.g., in a waveguide core) in accordance with the principal of total internal reflection.

Displays (e.g., projectors) may be mounted in nose bridge 28, at the outer left and right edges of structures 26-1 (e.g., when device 10 contains respective left and right projectors), and/or in other portions of head-mounted support structures 26. Display images from the displays may be coupled into respective left and right waveguides (e.g., through prisms and/or other input couplers). The waveguides may be formed form transparent layers such as glass or polymer layers (e.g., plates, films, etc.) that extend across the front of device 10 and overlap left and right eye boxes 30, respectively. The waveguides may be supported by nose bridge 28, by frame rims in support structures 26-1, and/or using other portions of head-mounted support structures (head-mounted eyeglass frame) 26. Each waveguide may have an embedded output coupler and/or an output coupler that is laminated to the surface of the waveguide structure. Each output coupler may be formed from a hologram, grating, or other optical output coupler structure. During operation, display images from the displays that are coupled into the waveguides travel laterally across the front of device 10 within the waveguides (e.g., image light is guided within the waveguides in accordance with the principal of total internal reflection). When the guided image light reaches the output couplers, the output couplers couple the image light out of the waveguides towards eye boxes 30 for viewing.

Device 10 may include one or more ambient light sensor(s). As shown in FIG. 2, device 10 can include an optical sensor such as an ambient light sensor 40 configured to detect or measure ambient light 42 from the scene or physical environment surrounding device 10. The term ambient light may refer to and be defined herein as light from the external physical environment surrounding device 10 and arriving at ambient light sensor 40. Ambient light 42 is therefore sometimes referred to as scene light, environment light, or incident light. A physical environment refers to a physical world that people can sense and/or interact with without the aid of an electronic device. In contrast, an extended reality (XR) environment refers to a wholly or partially simulated environment that people sense and/or interact with via an electronic device. For example, the XR environment may include augmented reality (AR) content, mixed reality (MR) content, virtual reality (VR) content, and/or the like. With an XR system, a subset of a person's physical motions, or representations thereof, are tracked, and, in response, one or more characteristics of one or more virtual objects simulated in the XR environment are adjusted in a manner that comports with at least one law of physics.

In accordance with some embodiments, ambient light sensor 40 may be configured to detect angular information associated with light 42. For instance, ambient light sensor 40 may be configured to detect an angle of incidence of the ambient light 42. Detecting the angle of incidence of ambient light 42 may be beneficial and technically advantageous by enabling various features, including but not limited to cosine correction of ambient lux values, correction of angularly-dependent transmission spectra, optical detection of orientation with respect to the sun's azimuth, shadow generation for augmented reality (AR) applications, and white point correction for gaze detection in AR applications, just to name a few.

Cosine correction of ambient lux values can allow for a more accurate determination of the ambient lux and to better adapt for display brightness. Correction of angularly-dependent transmission spectra can allow for the correction of the measured ambient white point by taking into account the angularly-dependent transmission spectra of various components within a display stack, which might include cosmetic inks, thin film structures, absorptive substrates, and/or other structures. The angle of incidence and location information obtained using a Global Positioning System within device 10 can be used to compute an angle between device 10 and the sun (e.g., to determine an orientation of device 10 with respect to the sun's azimuth). Optically detecting the orientation of device 10 may be technically superior to magnetic detection techniques since magnetic detection can be subject to external magnetic interference. For AR or extended reality (XR) applications, angular information on ambient light 42 can, for example, be used to more accurately render shadows for virtual objects to match the environment lighting conditions and/or be used to perform white point correction in a region aligned with a user's point of gaze so that virtual objects output by the display(s) appear more realistic. Ambient light sensor 40 with angle detection capabilities is sometimes referred to and defined herein as a "directional" ambient light sensor or an "angular detection" ambient light sensor.

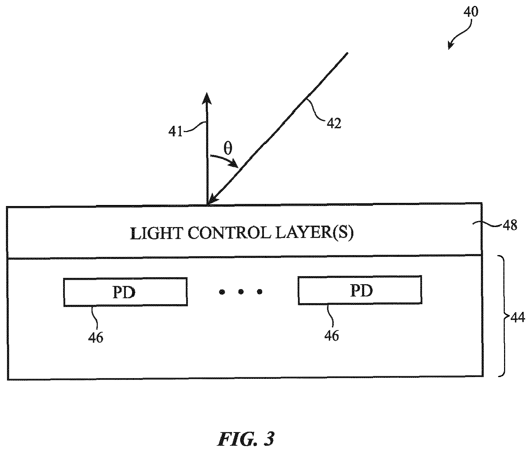

FIG. 3 is side view of illustrative directional ambient light sensor 40. As shown in FIG. 3, directional ambient light sensor 40 may include a substrate 44 (e.g., a semiconductor substrate), one or more photodetectors (PD) 46 formed in substrate 44, and one or more light control layer(s) 48 disposed on substrate 44. As another example, the various photodetectors 46 can be formed as part of different semiconductor substrates. As another example, the various photodetectors can be formed as discrete photosensitive components mounted on a common carrier board. Photodetectors 46 may be photodiodes, photoconductors, phototransistors, or other photosensitive elements. Light control layer(s) 48 can include light control structures formed in one or more layers. The light control structures within layers 48 can at least partially absorb or block ambient light 42. The light control structures may absorb or block ambient light 42 with an angle of incidence θ greater than a predetermined threshold.

As shown in FIG. 3, the angle of incidence θ of ambient light 42 can be defined with respect to a surface normal vector 41. This is merely illustrative. If desired, the angle of incidence of ambient light 42 can alternatively be defined with respect to the upper surface of ambient light sensor 40, which is equal to the complement of angle θ shown in FIG. 3. Ambient light 42 with angle θ equal to 0° may pass through light control layer 48 at maximum intensity and be equally detected by the various underlying photodetectors 46. As angle θ increases, an increasing amount of ambient light 42 will be absorbed by the light control structures within layer 48 and the underlying photodetectors 46 may receive light at different intensities. The variation in light intensities among the various photodetectors 46 can be used to determine the angle of incidence θ.

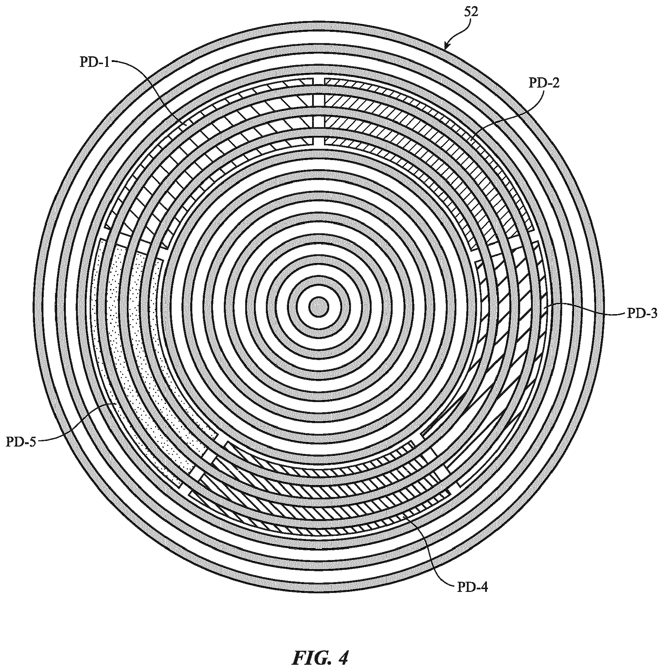

FIG. 4 is top (plan) view showing illustrative light control structures 52 that can be formed with light control layers 48 (see FIG. 3). As shown 4, light control structures 52 may include concentric rings. These rings may be formed from light absorbing, light blocking, or opaque material such as black ink, color inks (e.g., red ink, green ink, blue ink, etc.), metallic material, partially opaque material, or other light absorptive material. Layers 48 that include concentric opaque rings arranged in this way are sometimes collectively referred to and defined herein as a Moiré film. A Moiré film controls the angle of light traversing its layers using its geometry. The various rings can be spaced apart from one another by the same distance (as shown in the example of FIG. 4) or by different distances. The example of FIG. 4 having 14 separate concentric light control structures 52 is merely illustrative. In general, light control structures 52 may include at least five concentric rings, five to ten concentric rings, 10 to 20 concentric rings, 20 to 30 concentric rings, 30-50 concentric rings, 50-100 concentric rings, or more than 100 concentric rings. The light control structures 52 need not be circular rings. If desired, the light control structures 52 may be configured using other radially symmetric structure or other periodic structure.

The light control structures 52 may be disposed over (above) multiple photodetectors. In the example of FIG. 4, light control structures 52 are formed on top of five separate photodetectors such as photodetectors PD-1, PD-2, PD-3, PD-4, and PD-5. Each of these photodetectors may have a ring segment shape. Each ring segment shaped photodetector may have a first curved edge positioned at a first radius from a center of the circular light control structures 52, a second curved edge positioned at a second radius greater than the first radius from the center, a first straight edge connecting first ends of the first and second curved edges, and a second straight edge connecting second ends of the first and second curved edges.

The ring segment shaped photodetectors may be positioned closer to the outermost ring or can be positioned closer to the innermost ring. The example of FIG. 4 in which the circular light control structures 52 are disposed over five identical ring segment shaped photodetectors is merely illustrative. In other embodiments, the light control structures 52 can be disposed over at least three ring segment shaped photodetectors, at least four ring segment shaped photodetectors, five to ten ring segment shaped photodetectors, three to twenty identical ring segment shaped photodetectors, or more than ten ring segment shaped photodetectors. A higher number of photodetectors can provide greater resolution in azimuthal angle detection at the expense of greater complexity in the photodetector control/readout mechanism. A ratio between the various photodetectors, along with the overall light intensity reading, can be used compute the angle of incidence.

The example of FIG. 4 showing multiple photodetectors each having a ring segment shape is illustrative. As another example, the photodetectors disposed under the light control structures 52 can have a wedge (pie) shape, a triangular shape, a trapezoidal shape, or other suitable shape.

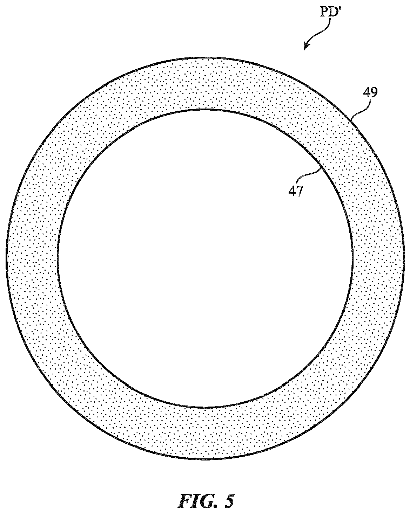

The example of FIG. 4 showing multiple photodetectors divided into different segments is merely illustrative. FIG. 5 shows another embodiment with a single photodetector PD' that can be formed under the light control structures 52 of FIG. 4. As shown in the top (plan) view of FIG. 5, photodetector PD' may be an annular photodiode region. Photodetector PD' may be a ring shaped photodiode with an inner (circular) peripheral edge 47 and an outer (circular) peripheral edge 49. Photodetector PD' can sometimes be referred to as having a donut shape. Compared to the embodiment of FIG. 4 having multiple separate photodetector regions, photodetector PD' of FIG. 5 requires a simpler control/readout mechanism and exhibits a larger overall photo-sensing region and can therefore provide a comparatively higher signal-to-noise ratio (SNR).

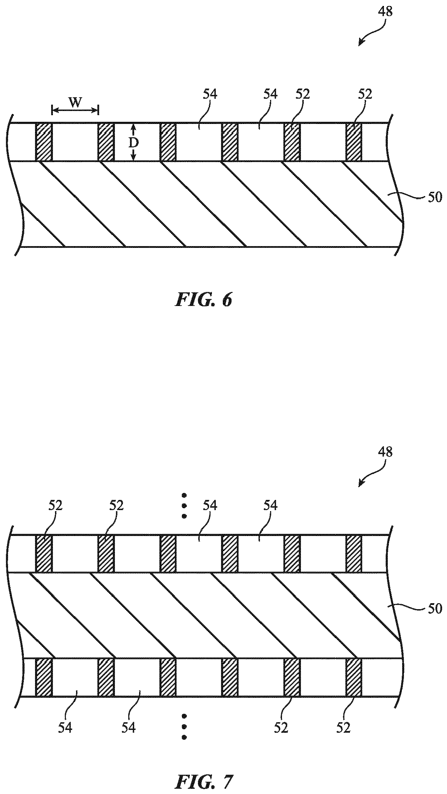

FIG. 6 is a cross-sectional side view of illustrative light control layers 48 having light control structures 52 disposed on one side of a substrate 50 in accordance with some embodiments. Substrate 50 may be a glass substrate, a layer of clear polymer, or other transparent substrate layer. Substrate 50 may have an upper (top) surface and a lower (bottom) surface. As shown in FIG. 6, light control structures 52 may be deposited or otherwise disposed on the upper surface of substrate 50. Light control structures 52 may form rings or other periodic structures and may be formed from light absorbing, light blocking, or opaque material such as black ink, color inks (e.g., red ink, green ink, blue ink, etc.), metallic material, partially opaque material, or other light absorbing material deposited and patterned on the upper surface of substrate 50. Adjacent light control structures 52 may be separated by a distance W. Regions 54 between adjacent light control structures 52 can be filled by clear polymer material, other transparent material, or air (e.g., forming air gaps or voids between adjacent light control structures 52). Light control structures 52 may each have a depth (or height) D. The spacing W and height D of the light control structures 52 (sometimes referred to as the aspect ratio of the openings or the geometry of the Moiré film) can be chosen or designed to provide the desired angular resolution or angle sensing capability for the directional ambient light sensor 40. The spacing W between adjacent light control structures 52 can be the same (as shown) or can be varied (dithered).

The example of FIG. 6 in which the light control structures 52 are disposed on the upper surface of substrate 50 is merely illustrative. In another embodiment, the light control structures 52 may instead be deposited or otherwise disposed on the lower surface of substrate 50. FIG. 7 shows another example in which light control structures 52 are disposed on two sides of a substrate 50. Substrate 50 may be a glass substrate, a layer of clear polymer, or other transparent substrate layer. Substrate 50 may have an upper (top) surface and a lower (bottom) surface. As shown in FIG. 7, a first set of light control structures 52 may be deposited or otherwise disposed on the upper surface of substrate 50, whereas a second set of light control structures 52 may be deposited or otherwise disposed on the bottom surface of substrate 50. The first and second sets of light control structures 52 may form rings or other periodic structures and may be formed from light absorbing, light blocking, or opaque material such as black ink, color inks (e.g., red ink, green ink, blue ink, etc.), metallic material, partially opaque material, or other light absorbing material deposited and patterned on the upper and lower surfaces of substrate 50. Regions 54 between adjacent light control structures 52 can be filled by clear polymer material, other transparent material, or air (e.g., forming air gaps or voids between adjacent light control structures 52). The geometry of the light control structures 52 on the upper and lower surfaces of substrate 50 can be chosen or designed to provide the desired angular resolution or angle sensing capability for the directional ambient light sensor 40. The spacing W between adjacent light control structures 52 can be the same (as shown) or can be varied (dithered).

The example of FIG. 7 in which the geometries of the light control structures 52 on the upper and lower surfaces of substrate 50 is identical is merely illustrative. As another example, the spacing between adjacent light control structures 52 on the upper surface of substrate 50 can be different than the spacing between adjacent light control structures 52 on the lower surface of substrate 50. As another example, the height of the light control structures 52 on the upper surface of substrate 50 can be different from the height of the light control structures 52 on the lower surface of substrate 50. As another example, the center of the light control structures 52 on the upper surface of substrate 50 can be horizontally shifted relative to the center of the light control structures 52 on the lower surface of substrate 50 (e.g., the light control structures 52 on the top and bottom surfaces of substrate 50 can be misaligned). The example of FIG. 6 in which light control layers 48 include light control structures 52 formed in two different layers is merely illustrative and is not intended to limit the scope of the present embodiments. In general, light control layers 48 can include light control structures 52 formed in three different layers, four different layers, five different layers, five to ten different layers, or more than ten different layers.

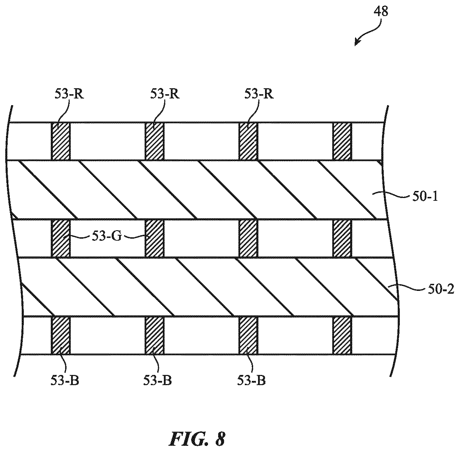

The examples of FIGS. 6 and 7 in which the light control structures 52 are formed using the same type of material such as black ink, color inks (e.g., red ink, green ink, blue ink, etc.), metallic material, partially opaque material, or other opaque material are illustrative. FIG. 8 shows another embodiment of light control layers 48 having different types of light absorbing material. As shown in FIG. 8, light control layers may include a first substrate layer 50-1 and a second substrate layer 50-2. Substrate layers 50-1 and 50-2 may be glass substrates, layers of clear polymer, or other transparent substrate layers. Substrate 50-1 may have an upper (top) surface and a lower (bottom) surface. Substrate 50-2 may have an upper (top) surface and a lower (bottom) surface.

A first type of light control structures such as light control structures 53-R may be deposited or otherwise disposed on the upper surface of substrate 50-1. Light control structures 53-R may form concentric rings (strips) or other periodic structures and may be formed from pigmented ink or thin film color filters configured to absorb red light (e.g., to absorb wavelengths in the red portion of the visible spectrum). Regions between adjacent light control structures 53-R can be filled by clear polymer material, other transparent material, or air (e.g., forming air gaps or voids between adjacent light control structures 53-R).

A second type of light control structures such as light control structures 53-G may be deposited or otherwise disposed between the lower surface of substrate 50-1 and the upper surface of substrate 50-2. Light control structures 53-G may form concentric rings (strips) or other periodic structures and may be formed from pigmented ink or thin film color filters configured to absorb green light (e.g., to absorb wavelengths in the green portion of the visible spectrum). Regions between adjacent light control structures 53-G can be filled by clear polymer material, other transparent material, or air (e.g., forming air gaps or voids between adjacent light control structures 53-G).

A third type of light control structures such as light control structures 53-B may be deposited or otherwise disposed on the lower surface of substrate 50-2. Light control structures 53-B may form concentric rings (strips) or other periodic structures and may be formed from pigmented ink or thin film color filters configured to absorb blue light (e.g., to absorb wavelengths in the blue portion of the visible spectrum). Regions between adjacent light control structures 53-B can be filled by clear polymer material, other transparent material, or air (e.g., forming air gaps or voids between adjacent light control structures 53-B). The spacing and height of light control structures 53-R, 53-G, and 53-B (sometimes referred to and defined herein as the aspect ratio of the openings formed by the light control structures) can be chosen or designed to provide the desired angular resolution or angle sensing capability for the directional ambient light sensor. The spacing W between adjacent light control structures 52 can be the same (as shown) or can be varied (dithered). Configured in this way, the signal generated from each of the underlying photodetectors can depend on the angle of incidence as well as the spectrum of the ambient light. If desired, white point can also be estimated from the different photodetector signals.

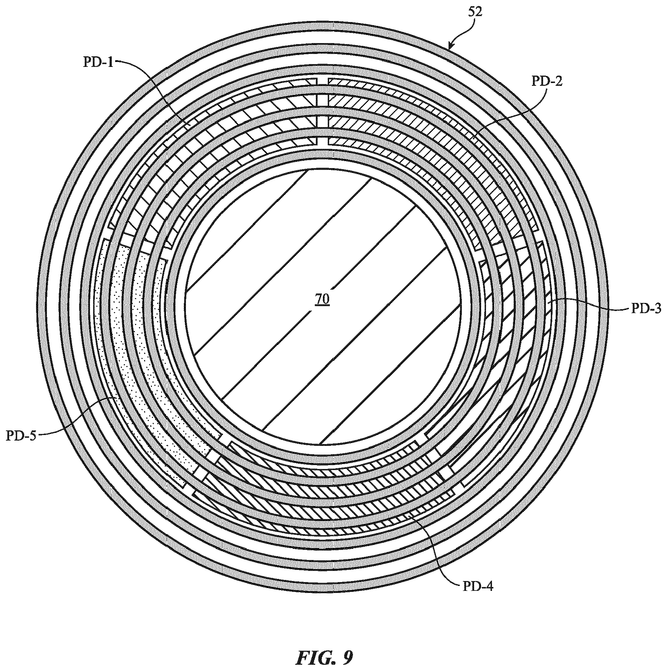

The example of FIG. 4 having light control structures 52 formed in the central region is merely illustrative. FIG. 9 shows another example in which the concentric circular light control structures 52 surround a diffuser structure 70 located in a center region. There are no light control structures 52 overlapping with the diffuser structure 70 in the center region. In other words, the Moiré film may have a hollow center portion that is occupied by diffuser 70. Diffuser 70 may scatter, diffuse, or otherwise homogenize any incidence light to produce homogenized light having an averaged color. The light control structures 52 surrounding diffuser 70 may be disposed over (above) multiple photodetectors. In the example of FIG. 9, light control structures 52 are formed on top of five separate photodetectors such as photodetectors PD-1, PD-2, PD-3, PD-4, and PD-5. Each of these photodetectors may have a ring segment shape. The ring segment shaped photodetectors may be positioned closer to the outermost ring.

The example of FIG. 9 in which the circular light control structures 52 are disposed over five identical ring segment shaped photodetectors is merely illustrative. In other embodiments, the light control structures 52 can be disposed over at least three ring segment shaped photodetectors, at least four ring segment shaped photodetectors, five to ten ring segment shaped photodetectors, or more than ten ring segment shaped photodetectors. The light control structures 52 can optionally cover at least 10% of the total photosensitive area, at least 20% of the total photosensitive, at least 30% of the total photosensitive area, at least 40% of the total photosensitive area, at least 50% of the total photosensitive area, at least 60% of the total photosensitive area, 1-70% of the total photosensitive area, or other percentage of the total photodetector area. A higher number of photodetectors can provide greater resolution in azimuthal angle detection at the expense of greater complexity in the photodetector control/readout mechanism. A ratio between the various photodetectors, along with the overall light intensity reading, can be used compute the angle of incidence.

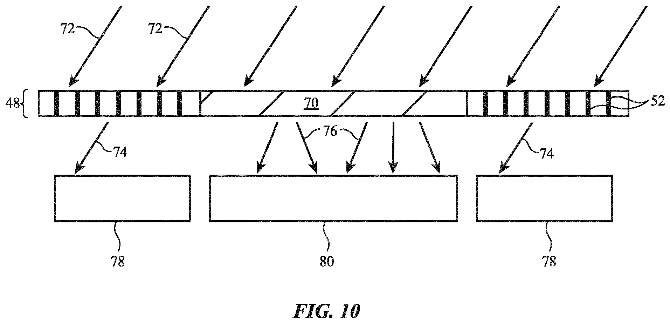

FIG. 10 is side view of light control structures 52 and diffuser 70 of FIG. 9 disposed over photodetectors 78 and a color sensor 80 in accordance with some embodiments. As shown in FIG. 10, light control layers 48 may include one or more layers of light control structures 52 surrounding light diffuser 70. The light control structures 52 can be formed on one side of a transparent substrate layer (see, e.g., FIG. 6), on two different sides of a transparent substrate (see, e.g., FIG. 7), in three different layers, etc. The light control structures 52 and diffuser 70 can optionally be formed in the same plane as shown in FIG. 10. If desired, light control structures 52 and diffuser 70 can be formed in slightly different or offset planes (e.g., light control structures 52 can be formed above or below diffuser layer 70).

Photodetectors 78 can be formed directly below light control structures 52. Photodetectors 78 of FIG. 10 may represent two different photodiodes formed underneath the light control structures 52. As an example, the photodetector 78 shown to the left of color sensor 80 in FIG. 10 may represent photodiode PD-1 in FIG. 9, whereas the photodetector 78 shown to the right of color sensor 80 in FIG. 10 may represent photodiode PD-3 in FIG. 9. As another example, photodetector 78 of FIG. 10 may represent the same contiguous photodiode if an annular (donut-shaped) photodiode were to be employed within the ambient light sensor 40. Photodetector(s) 78 formed under the light control structures 52 can be used to detect angular information and are thus sometimes referred to as angle photodetectors or angular sensing photodetectors.

Color sensor 80 may be formed directly below diffuser layer 70. Diffuser layer 70 may be configured to spatially homogenize incoming light 72 to produce diffused or scattered light 76. The diffused light 76 can be sensed by color sensor 80 to produce an average color reading. Configured in this way, the surrounding (peripheral) angular sensing photodetectors 78 can be used to obtain angular information while the central sensor 80 can be used to obtain color information. In some embodiments, photodetectors 78 and color sensor 80 can be formed in the same plane (e.g., photodetectors 78 and color sensor 80 can be formed in the same semiconductor substrate). This is illustrative. As another example, the angle sensing photodetectors 78 and color sensor 80 can be formed as part of separate sensors or in different semiconductor substrates. If desired, angle sensing photodetectors 78 and color sensor 80 can optionally be formed in different planes (e.g., photodiodes 78 can be formed at least partially above or below the photodiodes in color sensor 80).

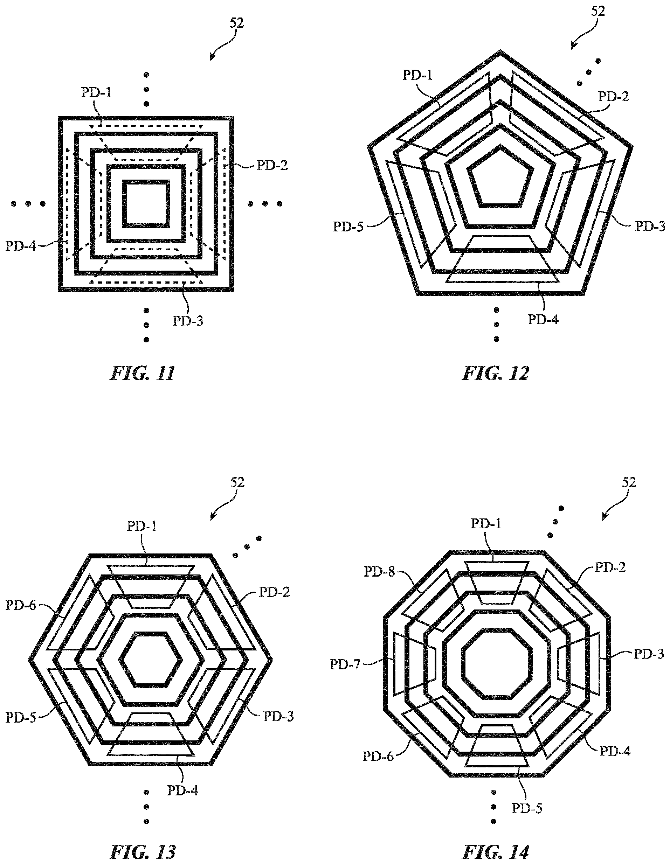

The embodiments of at least FIGS. 4 and 9 in which the light control structures 52 are concentric circular rings are exemplary and not intended to limit the scope of the present embodiments. FIG. 11 shows another embodiment in which the light control structures 52 are implemented as concentric square-shaped or rectangular strips (sometimes referred to as loops). The square-shaped strips 52 can be formed over at least four different photodetectors PD-1, PD-2, PD-3, and PD-4. The four photodetectors can have a trapezoidal shape or footprint (as an example). The photodetectors can have other shapes, if desired. Alternatively, a single photodetector forming a square-shaped band can be employed for higher SNR. If desired, a diffuser layer can optionally be formed within a hole at the center of the light control structures 52 and a color sensor can be formed directly under that diffuser layer.

FIG. 12 shows another embodiment in which the light control structures 52 are implemented as concentric pentagonal strips (sometimes referred to as loops). The pentagonal strips 52 can be formed over at least five separate photodetectors PD-1, PD-2, PD-3, PD-4, and PD-5. The five photodetectors can each have a trapezoidal shape or footprint (as an example). The photodetectors can have other shapes, if desired. Alternatively, a single photodetector forming a pentagon-shaped band can be employed for higher SNR. If desired, a diffuser layer can optionally be formed within a hole at the center of the light control structures 52 and a color sensor can be formed directly under that diffuser layer.

FIG. 13 shows another embodiment in which the light control structures 52 are implemented as concentric hexagonal strips (sometimes referred to as loops). The hexagonal strips 52 can be formed over at least six separate photodetectors PD-1, PD-2, PD-3, PD-4, PD-5, and PD-6. The six photodetectors can each have a trapezoidal shape or footprint (as an example). The photodetectors can have other shapes, if desired. Alternatively, a single photodetector forming a hexagon-shaped band can be employed for higher SNR. If desired, a diffuser layer can optionally be formed within a hole at the center of the light control structures 52 and a color sensor can be formed directly under that diffuser layer.

FIG. 14 shows another embodiment in which the light control structures 52 are implemented as concentric octagonal strips (sometimes referred to as loops). The octagonal strips 52 can be formed over at least eight separate photodetectors PD-1, PD-2, PD-3, PD-4, PD-5, PD-6, PD-7, and PD-8. The eight photodetectors can each have a trapezoidal shape or footprint (as an example). The photodetectors can have other shapes, if desired. Alternatively, a single photodetector forming a octagon-shaped band can be employed for higher SNR. If desired, a diffuser layer can optionally be formed within a hole at the center of the light control structures 52 and a color sensor can be formed directly under that diffuser layer.

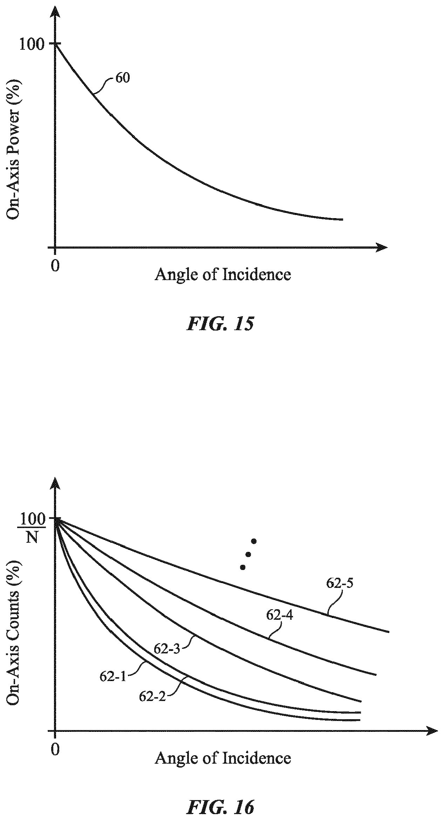

FIG. 15 is a plot showing an angular response 60 of an ambient light sensor 40 with only a single photodetector in accordance with some embodiments (see, e.g., the embodiment of FIG. 5). As shown by curve 60 in FIG. 15, the on-axis power sensed by the single photodetector decreases as a function of the angle of incidence θ. Thus, a power or intensity reading obtained from the single photodetector can be used to determine the angle of incidence using the angular response relationship shown in FIG. 15 (e.g., using a lookup table or other process). This angular response can be calibrated at the factory or in a laboratory and/or can optionally be fine-tuned during normal usage.

FIG. 16 is a plot showing an angular response of an ambient light sensor 40 with multiple photodetectors in accordance with some embodiments (see, e.g., the embodiments of FIGS. 4, 9, and 11-14). Curves 62-1, 62-2, 62-3, 62-4, and 62-5 illustrate the individual responses of five different photodetectors, which are all functions of the angle of incidence θ. The y-axis plots on-axis counts as a percentage, where N is equal to the total number of photodetectors. Examining the response of individual photodetectors can provide more resolution in the azimuthal angle. Computing a ratio of the photodiodes can yield even better angular resolution at higher angles and can removed light source dependent intensity. This angular response can be calibrated at the factory or in a laboratory and/or can optionally be fine-tuned during normal usage.

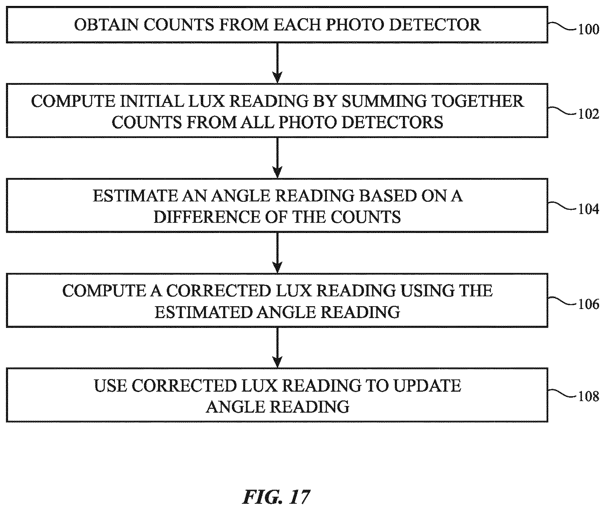

FIG. 17 is a flow chart of illustrative steps for operating an ambient light sensor 40 with multiple photodetector configured to provide angular detection capabilities in accordance with some embodiments. During the operations of block 100, the counts from each of the multiple photodetectors can be collected (e.g., using readout or control circuits within control circuitry 16 of FIG. 1). During the operations of block 102, the associated sensor readout or sensor control circuitry can be used to compute an initial lux (illuminance) reading. The initial lux reading can be computed by combining or summing together the counts from all of the photodetectors. If ambient light sensor 40 includes only one contiguous angular sensing photodetector, then the operations of blocks 100 and 102 can be merged into a single step (e.g., the count output from the single photodiode can be used directly as the initial lux reading).

During the operations of block 104, the sensor control circuitry can be used to estimate an angle reading based on a difference of the various counts. The photodetector(s) with the maximum count can first be identified. The angle reading may be a function of the difference of the counts of the individual photodetectors relative to the maximum count value. If all the counts are equal, then the angle of incidence θ is equal to 0°. As the incident light becomes steeper (with respect to the sensing surface of sensor 40), the difference in count of each photodetector relative to the maximum count value increases, thereby resulting in a detected angle of incidence θ with a higher value. If desired, ratios of the counts can be computed during the operations of block 104. As an example, count ratios can be computed relative to the maximum count value. As another example, count ratios can be computed between respective pairs of photodetectors.

During the operations of block 106, the sensor control circuitry can be used to compute a corrected lux (illuminance) reading based on the estimated angle reading computed during block 104. During the operations of block 108, the corrected lux reading can be used to update the angle reading. The operations of blocks 100-108 can be repeated to converge to a unique angular reading or until some threshold is met (e.g., when the number of iterations exceeds a predetermined threshold or until a deviation from a prior iteration is less than a given threshold value).

The operations of FIG. 17 are illustrative. In other embodiments, the sensor readout and control circuitry can use machine learning algorithms, can analyze other inputs, can rely on single-step calculations, or other angle computation algorithms. In some embodiments, one or more of the described operations may be modified, replaced, or omitted. In some embodiments, one or more of the described operations may be performed in parallel. In some embodiments, additional processes may be added or inserted between the described operations. If desired, the order of certain operations may be reversed or altered and/or the timing of the described operations may be adjusted so that they occur at slightly different times. In some embodiments, the described operations may be distributed in a larger system.

In accordance with an embodiment, an electronic device is provided that includes an optical sensor configured to receive ambient light and having one or more photodetectors, and light control layers disposed over the one or more photodetectors and including light control structures forming concentric strips of opaque material and control circuitry configured to compute angular information associated with the received ambient light based on readings generated from the one or more photodiodes.

In accordance with another embodiment, the concentric strips include circular concentric strips of opaque material.

In accordance with another embodiment, the opaque material includes black ink.

In accordance with another embodiment, the optical sensor includes a transparent substrate having a first surface and a second surface opposing the first surface, and the light control structures are disposed on the first surface of the transparent substrate.

In accordance with another embodiment, the optical sensor further includes additional light control structures forming concentric strips of opaque material and a transparent substrate having a first surface and a second surface opposing the first surface, the light control structures are disposed on the first surface of the transparent substrate and the additional light control structures are disposed on the second surface of the transparent substrate.

In accordance with another embodiment, the optical sensor includes a single annular photodetector having an inner peripheral edge located a first radius from a center of the concentric strips and having an outer peripheral edge located a second radius, greater than the first radius, from the center of the concentric strips.

In accordance with another embodiment, the one or more photodetectors include a plurality of ring segment shaped photodetectors.

In accordance with another embodiment, the one or more photodetectors include between 3 and 20 identical photodetectors.

In accordance with another embodiment, the light control layers include a diffuser surrounded by the concentric strips of opaque material.

In accordance with another embodiment, the optical sensor further includes a color sensor disposed below the diffuser, and the color sensor is surrounded by the one or more photodetectors.

In accordance with an embodiment, a method of operating an optical sensor is provided that includes with a plurality of photodetectors in the optical sensor, outputting corresponding count values, the optical sensor includes a Moiré film covering the plurality of photodetectors, computing a lux reading by combining the count values output from the plurality of photodetectors and estimating an angle reading based a difference of the count values.

In accordance with another embodiment, the method includes computing a corrected lux reading based on the estimated angle reading.

In accordance with another embodiment, the method includes updating the angle reading based on the corrected lux reading.

In accordance with another embodiment, the method includes identifying a maximum count value from among the count values.

In accordance with another embodiment, the method includes computing ratios of respective pairs of the count values.

In accordance with an embodiment, an optical sensor is provided that includes one or more photodetectors and light control layers disposed over the one or more photodetectors and including a transparent substrate, a first layer of light control structures forming concentric strips on a first surface of the transparent substrate, and a second layer of light control structures forming concentric strips on a second surface of the transparent substrate.

In accordance with another embodiment, the first and second layers of light control structures form concentric strips of opaque material.

In accordance with another embodiment, the light control layers further include a third layer of light control structures forming concentric strips and an additional transparent substrate interposed between the second layer of light control structures and the third layer of light control structures.

In accordance with another embodiment, the concentric strips in the first layer of light control structures are formed from a first type of material, the concentric strips in the second layer of light control structures are formed from a second type of material different than the first type of material and the concentric strips in the third layer of light control structures are formed from a third type of material different than the first and second types of material.

In accordance with another embodiment, the first type of material includes pigmented ink configured to absorb red light, the second type of material includes pigmented ink configured to absorb green light, and the third type of material includes pigmented ink configured to absorb blue light.

The foregoing is merely illustrative and various modifications can be made to the described embodiments. The foregoing embodiments may be implemented individually or in any combination.

Exemplary embodiments of the present disclosure are set out in the following items:
1. An electronic device comprising:
   an optical sensor configured to receive ambient light and having
      one or more photodetectors, and
      light control layers disposed over the one or more photodetectors and including light control structures forming concentric strips of opaque material; and
   control circuitry configured to compute angular information associated with the received ambient light based on readings generated from the one or more photodiodes.
2. The electronic device of claim 1, wherein the concentric strips comprise circular concentric strips of opaque material.
3. The electronic device of claim 2, wherein the opaque material comprises black ink.
4. The electronic device of any of claims 1-3, wherein the optical sensor comprises a transparent substrate having a first surface and a second surface opposing the first surface, and wherein the light control structures are disposed on the first surface of the transparent substrate.
5. The electronic device of any of claims 1-4, wherein:
   the optical sensor further comprises additional light control structures forming concentric strips of opaque material and a transparent substrate having a first surface and a second surface opposing the first surface;
   the light control structures are disposed on the first surface of the transparent substrate; and
   the additional light control structures are disposed on the second surface of the transparent substrate.
6. The electronic device of any of claims 1-5, wherein the optical sensor comprises a single annular photodetector having an inner peripheral edge located a first radius from a center of the concentric strips and having an outer peripheral edge located a second radius, greater than the first radius, from the center of the concentric strips.
7. The electronic device of any of claims 1-6, wherein the one or more photodetectors comprise a plurality of ring segment shaped photodetectors.
8. The electronic device of any of claims 1-7, wherein the one or more photodetectors comprise between 3 and 20 identical photodetectors.
9. The electronic device of any of claims 1-8, wherein the light control layers comprise a diffuser surrounded by the concentric strips of opaque material.
10. The electronic device of claim 9, wherein the optical sensor further comprises a color sensor disposed below the diffuser, and wherein the color sensor is surrounded by the one or more photodetectors.
11. A method of operating an optical sensor, comprising:
   with a plurality of photodetectors in the optical sensor, outputting corresponding count values, wherein the optical sensor includes a Moiré film covering the plurality of photodetectors;
   computing a lux reading by combining the count values output from the plurality of photodetectors; and
   estimating an angle reading based a difference of the count values.
12. The method of claim 11, further comprising computing a corrected lux reading based on the estimated angle reading.
13. The method of claim 12, further comprising updating the angle reading based on the corrected lux reading.
14. The method of any of claims 11+13, further comprising identifying a maximum count value from among the count values.
15. The method of any of claims 11-14, further comprising computing ratios of respective pairs of the count values.
16. An optical sensor comprising:
   one or more photodetectors; and
   light control layers disposed over the one or more photodetectors and including
      a transparent substrate,
      a first layer of light control structures forming concentric strips on a first surface of the transparent substrate, and
      a second layer of light control structures forming concentric strips on a second surface of the transparent substrate.
17. The optical sensor of claim 16, wherein the first and second layers of light control structures form concentric strips of opaque material.
18. The optical sensor of any of claims 16-17, wherein the light control layers further comprise:
   a third layer of light control structures forming concentric strips; and
   an additional transparent substrate interposed between the second layer of light control structures and the third layer of light control structures.
19. The optical sensor of claim 18, wherein:
   the concentric strips in the first layer of light control structures are formed from a first type of material;
   the concentric strips in the second layer of light control structures are formed from a second type of material different than the first type of material; and
   the concentric strips in the third layer of light control structures are formed from a third type of material different than the first and second types of material.
20. The optical sensor of claim 19, wherein:
   the first type of material comprises pigmented ink configured to absorb red light;
   the second type of material comprises pigmented ink configured to absorb green light; and
   the third type of material comprises pigmented ink configured to absorb blue light.

## Claims

1. An electronic device comprising:
an optical sensor configured to receive ambient light and having
one or more photodetectors, and
light control layers disposed over the one or more photodetectors and including light control structures forming concentric strips of opaque material; and
control circuitry configured to compute angular information associated with the received ambient light based on readings generated from the one or more photodiodes.

2. The electronic device of claim 1, wherein the concentric strips comprise circular concentric strips of opaque material.

3. The electronic device of claim 2, wherein the opaque material comprises black ink.

4. The electronic device of any of claims 1-3, wherein the optical sensor comprises a transparent substrate having a first surface and a second surface opposing the first surface, and wherein the light control structures are disposed on the first surface of the transparent substrate.

5. The electronic device of any of claims 1-4, wherein:
the optical sensor further comprises additional light control structures forming concentric strips of opaque material and a transparent substrate having a first surface and a second surface opposing the first surface;
the light control structures are disposed on the first surface of the transparent substrate; and
the additional light control structures are disposed on the second surface of the transparent substrate.

6. The electronic device of any of claims 1-5, wherein the optical sensor comprises a single annular photodetector having an inner peripheral edge located a first radius from a center of the concentric strips and having an outer peripheral edge located a second radius, greater than the first radius, from the center of the concentric strips.

7. The electronic device of any of claims 1-6, wherein the one or more photodetectors comprise a plurality of ring segment shaped photodetectors.

8. The electronic device of any of claims 1-7, wherein the one or more photodetectors comprise between 3 and 20 identical photodetectors.

9. The electronic device of any of claims 1-8, wherein the light control layers comprise a diffuser surrounded by the concentric strips of opaque material.

10. The electronic device of claim 9, wherein the optical sensor further comprises a color sensor disposed below the diffuser, and wherein the color sensor is surrounded by the one or more photodetectors.

11. A method of operating an optical sensor, comprising:
with a plurality of photodetectors in the optical sensor, outputting corresponding count values, wherein the optical sensor includes a Moiré film covering the plurality of photodetectors;
computing a lux reading by combining the count values output from the plurality of photodetectors; and
estimating an angle reading based a difference of the count values.

12. The method of claim 11, further comprising computing a corrected lux reading based on the estimated angle reading.

13. The method of claim 12, further comprising updating the angle reading based on the corrected lux reading.

14. The method of any of claims 11-13, further comprising identifying a maximum count value from among the count values.

15. The method of any of claims 11-14, further comprising computing ratios of respective pairs of the count values.
